# FASCICULE DE BREVET EUROPEEN

(11) **EP 3 882 964 B1**
(45) Date de publication et mention de la délivrance du brevet: **19.02.2025**
(21) Numéro de dépôt: 21163291.4
(22) Date de dépôt: 17.03.2021
(51) Int. Cl.: H01L 23/473

(54) **PUCE À REFROIDISSEMENT LIQUIDE**
FLÜSSIGKEITSGEKÜHLTER CHIP
CHIP WITH COOLING LIQUID

(30) Priorité: 19.03.2020 FR 2002710
(43) Date de publication de la demande: 22.09.2021
(73) Titulaire: Commissariat à l'Energie Atomique et aux Energies Alternatives, 75015 Paris (FR)
(72) Inventeur: SIMON, Gilles, 38054 Grenoble Cedex 09 (FR)
(74) Mandataire: Cabinet Beaumont

(56) Documents cités:
- EP-A1- 1 465 252
- EP-A2- 1 739 746
- JP-A- H01 206 634
- JP-A- H04 122 054
- US-A1- 2004 113 265
- US-A1- 2006 160 327
- US-B1- 7 265 976

## Description

### Domaine technique

La présente description concerne de façon générale les dispositifs électroniques et, plus particulièrement, les puces électroniques destinées à être refroidies par une circulation de liquide.

### Technique antérieure

Dans des dispositifs tels que des supercalculateurs, des serveurs informatiques ou des modules de puissance, on utilise des puces fonctionnant généralement à haute fréquence et pouvant être parcourues par des courants électriques intenses (de l'ordre de l'ampère à la dizaine d'ampères). Cela entraîne souvent, de façon indésirable, des dégagements de chaleur importants. On cherche alors à évacuer cette chaleur, afin de maintenir les puces dans des plages de températures de fonctionnement adéquates. Pour cela, on équipe typiquement chaque puce d'un dissipateur destiné à échanger, avec un fluide caloporteur, une partie de l'énergie thermique dégagée par la puce.

Le dissipateur est toutefois généralement séparé de la puce par au moins une couche d'interface. Dans des domaines tels que le calcul haute performance, où il existe un besoin de dissiper des puissances thermiques toujours plus grandes, la résistance thermique de cette couche d'interface nuit aux échanges caloriques entre la puce et le fluide caloporteur. Cela dégrade par conséquent l'efficacité de refroidissement des puces par le dissipateur.

Le document EP 1465252 décrit un dispositif et un procédé pour le refroidissement direct par convection de la surface exposée d'une puce de circuit intégré.

Le document EP 1739746 décrit un système électronique refroidi par fluide.

Le document JP H01 206634 décrit un dispositif semiconducteur dans une structure de boîtier.

Le document US 7265976 décrit un système de gestion thermique à microcanaux.

Le document US 2004/113265 décrit un refroidissement localisé d'une face arrière d'une puce avec des vannes intelligentes intégrées.

Le document US 2006/160327 décrit une plaquette SOI comprenant des canaux de refroidissement et son procédé de fabrication.

Le document JP H04 122054 décrit un dispositif semiconducteur.

### Résumé de l'invention

Il existe un besoin d'améliorer le refroidissement des puces électroniques actuelles.

Un mode de réalisation pallie tout ou partie des inconvénients des puces électroniques connues.

Un mode de réalisation prévoit une puce électronique formée dans et sur un substrat semiconducteur comportant, du côté d'une première face, au moins un composant actif et, du côté d'une deuxième face opposée à la première face, au moins un premier canal de circulation d'un liquide destiné à refroidir la puce, chaque premier canal étant défini par un évidement depuis la deuxième face du substrat se prolongeant longitudinalement, hors de la puce, à l'intérieur du bloc.

Selon un mode de réalisation, chaque évidement a la forme d'une rainure droite ouverte côté deuxième face du substrat.

Selon un mode de réalisation, le fond de chaque rainure est séparé de la première face du substrat par une distance comprise entre 20 µm et 250 pm, de préférence entre 20 µm et 40 µm.

Selon un mode de réalisation, le premier canal présente, vu de dessus, une forme de serpentin.

Selon un mode de réalisation, chaque évidement a la forme d'un secteur de disque bordé latéralement par deux ailettes radiales.

Un mode de réalisation prévoit un dispositif électronique comprenant :
une puce telle que décrite ; et
un capot situé en regard de la deuxième face du substrat.

Selon un mode de réalisation, le capot forme un espace de distribution du liquide dans chaque canal.

Selon un mode de réalisation, le capot comporte un orifice d'injection de liquide et un orifice d'évacuation de liquide.

Selon un mode de réalisation, chaque premier canal présente une première extrémité située à proximité de l'orifice d'injection de liquide et une deuxième extrémité située à proximité de l'orifice d'évacuation de liquide.

Selon un mode de réalisation, l'orifice d'injection de liquide et l'orifice d'évacuation de liquide forment, par rapport à une normale à la face supérieure du capot, un angle compris entre 45° et 70°.

Selon un mode de réalisation, la puce est entourée, sur toutes ses faces latérales, par un bloc en un matériau organique, de préférence une résine époxy.

Selon un mode de réalisation, le bloc comporte au moins un deuxième canal de circulation d'un liquide.

Selon un mode de réalisation, le capot est en un matériau organique, de préférence une résine époxy.

Un mode de réalisation prévoit un procédé de fabrication d'un dispositif tel que décrit, comprenant les étapes suivantes :
déposer une couche d'oxyde sur la deuxième face du substrat ;
graver la couche d'oxyde ;
réaliser le premier canal de circulation au droit d'une portion de deuxième face du substrat non revêtue par la couche d'oxyde ; et
fixer le capot en regard de la deuxième face du substrat.

Selon un mode de réalisation, le premier canal de circulation est réalisé par gravure ionique réactive.

### Brève description des dessins

Ces caractéristiques et avantages, ainsi que d'autres, seront exposés en détail dans la description suivante de modes de réalisation et modes de mise en oeuvre particuliers faite à titre non limitatif en relation avec les figures jointes parmi lesquelles :
la figure 1 est une vue en coupe, schématique et partielle, illustrant un exemple de dispositif connu comprenant une puce électronique équipée d'un dissipateur thermique ;
la figure 2 est une vue en perspective, schématique et partielle, illustrant un mode de réalisation d'un dispositif électronique destiné à être refroidi par une circulation de liquide ;
la figure 3 est une vue de dessus, schématique et partielle, du dispositif de la figure 2 ;
la figure 4 est une vue en coupe, selon le plan AA de la figure 3, schématique et partielle, du dispositif de la figure 2 ;
la figure 5 est une autre vue en coupe, selon le plan BB de la figure 3, schématique et partielle, du dispositif de la figure 2 ;
la figure 6 est une vue en perspective, schématique et partielle, illustrant un autre mode de réalisation d'un dispositif électronique destiné à être refroidi par une circulation de liquide ;
la figure 7 est une vue de dessus, schématique et partielle, du dispositif de la figure 6 ;
la figure 8 est une vue en coupe, schématique et partielle, illustrant un autre mode de réalisation d'un dispositif électronique ;
la figure 9 est une vue schématique, en perspective et en coupe, du dispositif de la figure 8 ;
la figure 10 est une vue de dessus, schématique et partielle, illustrant encore un autre mode de réalisation d'un dispositif électronique ;
la figure 11 est une vue en coupe, selon le plan CC de la figure 10, schématique et partielle, du dispositif de la figure 10 ;
la figure 12 est une vue en coupe, schématique et partielle, illustrant une étape d'un mode de mise en oeuvre d'un procédé de fabrication d'un dispositif électronique ;
la figure 13 est vue en coupe, schématique et partielle, illustrant une autre étape du mode de mise en oeuvre du procédé de fabrication d'un dispositif électronique ;
la figure 14 est vue en coupe, schématique et partielle, illustrant encore une autre étape du mode de mise en oeuvre du procédé de fabrication d'un dispositif électronique ;
la figure 15 est vue en coupe, schématique et partielle, illustrant encore une autre étape du mode de mise en oeuvre du procédé de fabrication d'un dispositif électronique ;
la figure 16 est vue en coupe, schématique et partielle, illustrant encore une autre étape du mode de mise en oeuvre du procédé de fabrication d'un dispositif électronique ;
la figure 17 est vue en coupe, schématique et partielle, illustrant encore une autre étape du mode de mise en oeuvre du procédé de fabrication d'un dispositif électronique ;
la figure 18 est vue en coupe, schématique et partielle, illustrant encore une autre étape du mode de mise en oeuvre du procédé de fabrication d'un dispositif électronique ; et
la figure 19 est une vue en perspective, schématique et partielle, d'une carte de circuit imprimé comportant un dispositif électronique à refroidissement liquide.

### Description des modes de réalisation

De mêmes éléments ont été désignés par de mêmes références dans les différentes figures. En particulier, les éléments structurels et/ou fonctionnels communs aux différents modes de réalisation et modes de mise en oeuvre peuvent présenter les mêmes références et peuvent disposer de propriétés structurelles, dimensionnelles et matérielles identiques.

Par souci de clarté, seuls les étapes et éléments utiles à la compréhension des modes de réalisation et modes de mise en oeuvre décrits ont été représentés et sont détaillés. En particulier, les composants électroniques intégrés aux puces décrites ne seront pas détaillés, les modes de réalisation et modes de mise en oeuvre décrits étant compatibles avec les composants électroniques usuellement intégrés à des puces.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence, sauf précision contraire, à l'orientation des figures.

Sauf précision contraire, les expressions "environ", "approximativement", "sensiblement", et "de l'ordre de" signifient à 10 % près, de préférence à 5 % près.

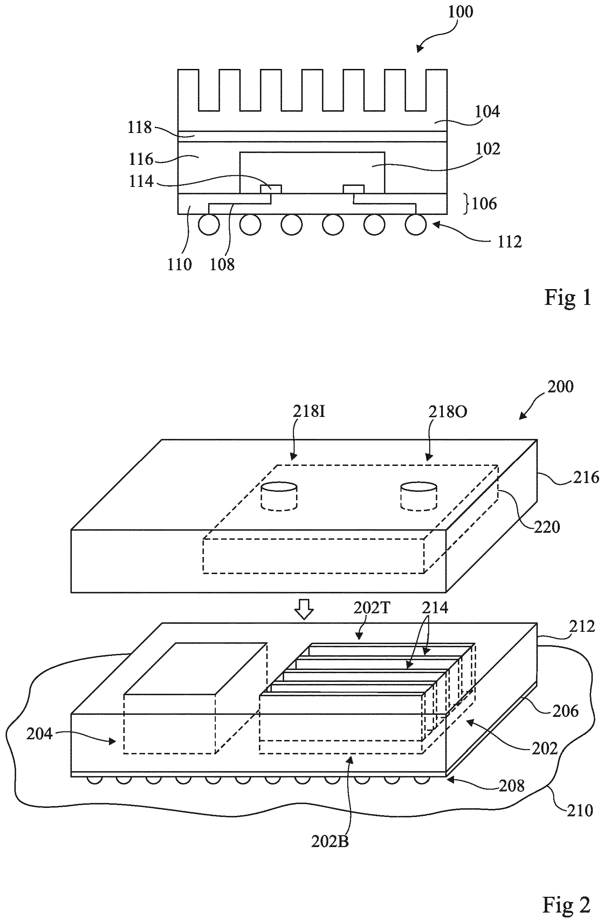

La figure 1 est une vue en coupe, schématique et partielle, illustrant un exemple de dispositif 100 comprenant une puce électronique 102 équipée d'un dissipateur thermique 104.

Dans l'exemple illustré en figure 1, la puce 102 est liée, du côté de sa face inférieure, à une structure 106 d'interconnexion. La structure 106 d'interconnexion comporte typiquement un empilement de couches en un matériau 108 électriquement conducteur, par exemple un métal, séparées par des couches en un matériau 110 électriquement isolant. Une matrice 112 de billes de soudure, située du côté de la face inférieure de la structure 106 d'interconnexion, permet de connecter électriquement et de fixer le dispositif 100 à un support (non représenté), par exemple une carte de circuit imprimé.

La structure 106 assure en particulier une fonction de connexion électrique entre des plots 114 de connexion de la puce 102 et les billes de soudure de la matrice 112. On tire en outre profit de la structure 106 d'interconnexion et de la matrice 112 de billes de soudure pour former une surface de connexion de la puce 102 plus importante que celle que l'on pourrait obtenir en utilisant uniquement les plots 114 de connexion. On facilite et on fiabilise ainsi la connexion électrique entre la puce 102 et la carte de circuit imprimé.

Dans l'exemple représenté, les faces latérales et la face supérieure de la puce 102 sont entourées par un bloc 116 d'encapsulation, formé du côté de la surface supérieure de la structure 106 d'interconnexion. Dans le cas où des composants actifs (non représentés), par exemple des transistors, ont été réalisés du côté de la face inférieure de la puce 102, le bloc 116 d'encapsulation permet notamment de protéger ces composants contre des agressions extérieures, telles qu'une exposition directe à l'humidité.

En figure 1, la face supérieure du bloc 116 d'encapsulation est revêtue d'une couche 118 d'interface entre le bloc 116 et le dissipateur thermique 104. La couche 118 est usuellement constituée d'un matériau dit d'interface thermique, c'est-à-dire un matériau permettant d'obtenir un bon couplage thermique entre le bloc 116 et le dissipateur 104. Dans certains cas, la couche d'interface 118 peut revêtir directement la face supérieure de la puce 102, la surface supérieure de la puce 102 affleurant alors par exemple la surface supérieure du bloc 116.

Le matériau de la couche 118 d'interface possède, en général, une résistance thermique largement inférieure à celle du matériau du bloc 116 d'encapsulation, sans toutefois atteindre une valeur optimale car elle doit répondre notamment à des besoins de planarisation, d'adhésivité, de coût et de facilité de mise en oeuvre. Dans l'exemple représenté où la face supérieure de la puce 102 est séparée de la couche 118 d'interface par une portion du bloc 116 d'encapsulation, la résistance thermique du matériau du bloc 116 d'encapsulation nuit à l'évacuation, vers le dissipateur thermique 104, de la chaleur produite par la puce 102 durant son fonctionnement. Cela dégrade par conséquent l'efficacité de refroidissement de la puce 102 du dispositif 100 par le dissipateur thermique 104.

Un autre inconvénient du dispositif 100 tient au fait que la puce 102 est séparée du dissipateur 104 par plusieurs interfaces entre des matériaux distincts. Dans l'exemple représenté, le dispositif 100 comporte plus précisément trois interfaces entre la puce 102 et le dissipateur 104 :
- une interface entre la face supérieure de la puce 102 et le bloc 116 d'encapsulation ;
- une autre interface entre la face supérieure du bloc 116 et la face inférieure de la couche 118 ; et
- encore une autre interface entre la face supérieure de la couche 118 et la face inférieure du dissipateur 104.

Chacune de ces interfaces tend à dégrader l'efficacité de refroidissement de la puce 102 du dispositif 100 par le dissipateur 104.

La figure 2 est une vue en perspective, schématique et partielle, illustrant un mode de réalisation d'un dispositif électronique 200 destiné à être refroidi par une circulation de liquide.

Le dispositif 200 comporte deux puces électroniques 202 et 204. À titre d'exemple, la puce électronique 202 est un microprocesseur et la puce électronique 204 est une mémoire. Les puces 202 et 204 font par exemple partie d'un dispositif 200 de type « système dans un boîtier » (System in Package - SiP).

Les puces électroniques 202 et 204 sont connectées, par l'intermédiaire d'une même structure 206 d'interconnexion, à une matrice 208 de billes de soudure. La structure 206 d'interconnexion du dispositif 200 de la figure 2 est, par exemple, analogue à la structure 106 d'interconnexion du dispositif 100 de la figure 1.

La structure 206 d'interconnexion et la matrice 208 de billes de soudure du dispositif 200 permettent, en particulier, de connecter des plots (non représentés) des puces 202 et 204 à des éléments de reprise de contact (non représentés) formés en surface d'un support 210, par exemple une carte de circuit imprimé, situé sous la matrice 208 de billes de soudure. La structure 206 d'interconnexion peut de surcroît permettre d'interconnecter des plots de la puce 202 et des plots de la puce 204 sans passer par la carte 210 de circuit imprimé.

On considère, dans l'orientation de la figure 2, que la puce 202 possède une face inférieure ou première face 202B comportant au moins un composant électronique actif tel qu'un transistor ou une diode. La face 202B est alors qualifiée de face active de la puce 202.

Dans la suite de la description, on considère que les composants formés du côté de la face 202B active de la puce 202 sont à l'origine d'un dégagement de chaleur pendant le fonctionnement de la puce 202. On suppose que l'on souhaite évacuer cette chaleur afin de refroidir la puce 202.

Les puces 202 et 204 sont entourées, sur leurs faces latérales respectives, par un bloc 212 d'encapsulation en un matériau organique, par exemple une résine époxy. Le bloc 212 d'encapsulation permet notamment de protéger la face 202B active de la puce 202 contre l'humidité.

La puce 202 possède en outre une face supérieure ou deuxième face 202T, opposée à la face active 202B. Selon un mode de réalisation, la face 202T de la puce 202 comporte des évidements 214. En d'autres termes, la puce 202 comporte, du côté de la face 202T, des ailettes séparées les unes des autres par les évidements 214. Les évidements 214 représentés en figure 2 sont en forme de rainures droites. Les évidements 214 constituent des canaux de circulation d'un liquide caloporteur, par exemple l'eau, destiné à refroidir la puce 202 durant son fonctionnement.

Les évidements 214 en forme de rainures sont ouverts côté face 202T et sont, de préférence, sensiblement parallèles entre eux. Les évidements 214 présentent de préférence des dimensions identiques (aux dispersions de fabrication près).

Un capot 216 est fixé sur la face supérieure du bloc 212 d'encapsulation des puces 202 et 204. Le capot 216 comporte un orifice 218I d'entrée ou d'injection de liquide et un autre orifice 2180 de sortie ou d'évacuation de liquide.

Le capot 216 comporte en outre une cavité 220, située en regard des évidements 214, dans laquelle débouchent les orifices 218I et 2180. La cavité 220 forme un espace ou volume de distribution du liquide dans les canaux de circulation de la puce 202 formés par les évidements 214.

Un avantage du dispositif 200 tient au fait que les canaux 214, situés du côté de la face supérieure 202T de la puce 202, sont destinés à être mis directement en contact avec le liquide caloporteur. Dans le dispositif 200, les ailettes délimitant les canaux 214 de la puce 202 font ainsi office de dissipateur thermique. Cela permet d'améliorer l'efficacité de refroidissement de la puce 202, notamment par rapport à une structure analogue à celle du dispositif 100 (figure 1) dans laquelle au moins une couche est interposée entre la puce et le liquide caloporteur.

Un autre avantage du dispositif 200 tient au fait que la présence des évidements 214 permet de bénéficier, du côté de la face supérieure 202T de la puce 202, d'une surface d'échange plus importante que celle que l'on obtiendrait sans les évidements 214. Cela permet d'améliorer encore davantage l'efficacité de refroidissement de la puce 202.

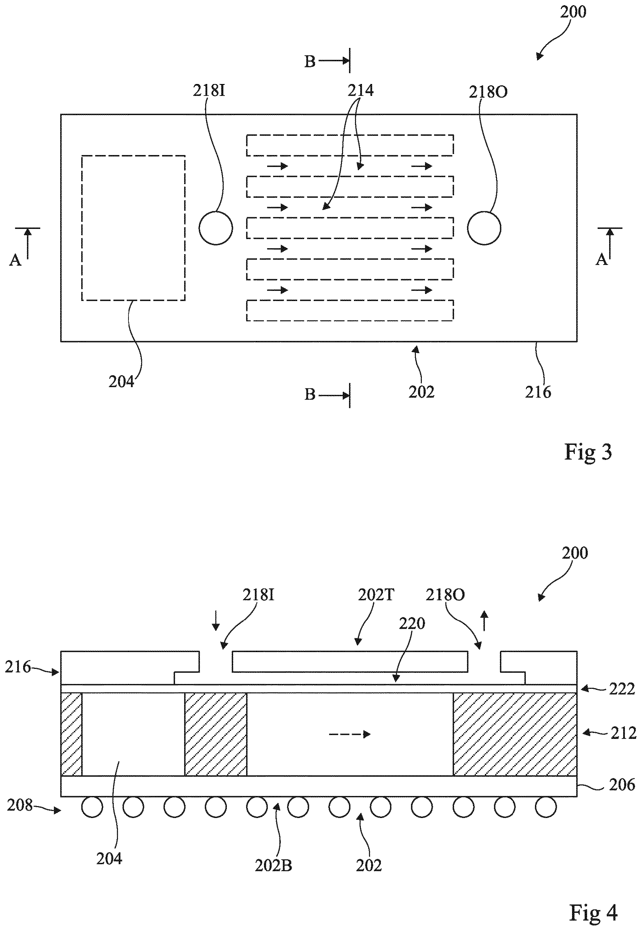

La figure 3 est une vue de dessus, schématique et partielle, du dispositif 200 de la figure 2.

Dans l'exemple représenté, l'orifice 218I d'injection de liquide est situé à proximité d'une extrémité des évidements 214 de la puce 202, tandis que l'orifice 2180 d'évacuation de liquide est situé à proximité de l'autre extrémité des évidements 214 de la puce 202. Cela permet de faire circuler le liquide sur toute la longueur des évidements 214 et ainsi d'optimiser les échanges thermiques entre la puce 202 à refroidir et le liquide circulant à l'intérieur des évidements 214.

Sous le capot 216, la circulation du liquide à l'intérieur des évidements 214 s'effectue depuis l'orifice 218I d'injection vers l'orifice 2180 d'évacuation. Dans l'orientation de la figure 3 où les orifices 218I et 2180 sont respectivement situés à gauche et à droite de la puce 202, la circulation de fluide à l'intérieur des évidements 214 est symbolisée par des flèches dirigées vers la droite.

On a représenté en figure 3 des évidements 214 qui présentent, vus de dessus, une forme rectangulaire. Cela n'est toutefois pas limitatif, les évidements 214 pouvant en pratique présenter, vus de dessus, une forme quelconque.

On a en outre représenté en figure 3 des évidements 214 qui s'étendent longitudinalement depuis une première face latérale de la puce 202 jusqu'à une deuxième face latérale de la puce 202, opposée à la première face. Cela n'est toutefois pas limitatif, les évidements 214 pouvant en pratique se loner longitudinalement hors de la puce 202, c'est-à-dire à l'intérieur du bloc 212 d'encapsulation. À titre de variante, les évidements 214 ne débouchent pas du côté des première et deuxième faces latérales de la puce 202.

La figure 4 est une vue en coupe, selon le plan AA de la figure 3, schématique et partielle, du dispositif 200 de la figure 2. En figure 4, le bloc 212 d'encapsulation est symbolisé par des zones hachurées.

La cavité 220 formée par le capot 216 est centrée par rapport à la puce 202 afin de permettre une distribution optimale du fluide dans les évidements 214 (figure 2). En figure 4, on a arbitrairement représenté un mode de réalisation dans lequel seule la puce 202 est refroidie par la circulation de liquide. En variante, la puce 204 est également refroidie par la circulation de liquide et possède alors par exemple, sur sa face supérieure, des évidements semblables à ceux de la puce 202.

Selon un mode de réalisation, le capot 216 est fixé, du côté de la face supérieure du bloc 212 d'encapsulation, sur une couche 222 de passivation reportée sur le bloc 212. La couche 222 est, par exemple, une couche d'oxyde. En variante, le capot 216 est fixé, du côté de la face supérieure du bloc 212 d'encapsulation, directement sur le bloc 212 (la couche 222 étant dans ce cas omise).

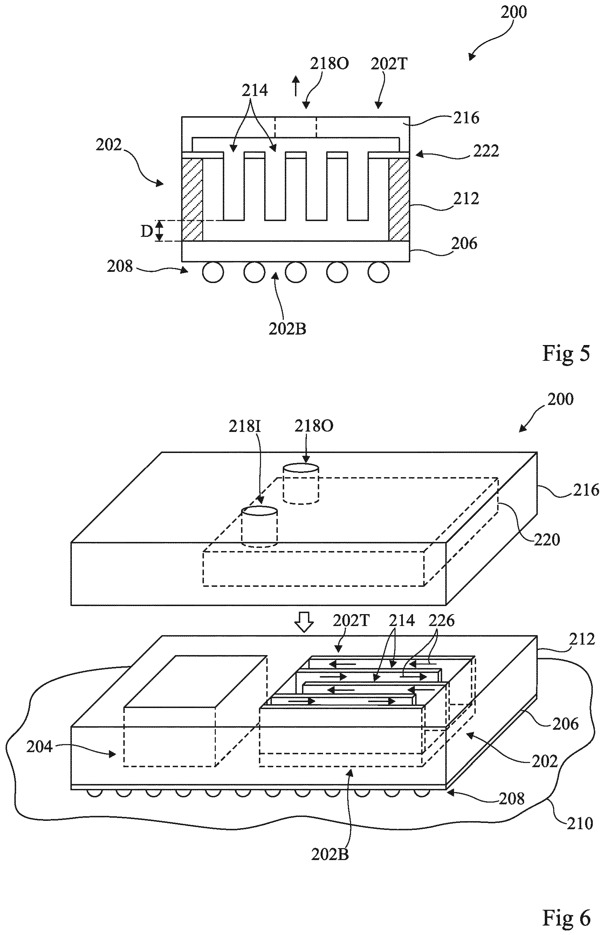

La figure 5 est une autre vue en coupe, selon le plan BB de la figure 3, schématique et partielle, du dispositif 200 de la figure 3. En figure 5, le bloc 212 d'encapsulation est symbolisé par des zones hachurées.

La couche 222 de passivation est interrompue au niveau des évidements 214 afin de permettre la circulation de liquide du côté de la face supérieure 202T de la puce 202.

En figure 5, le fond de chaque évidement 214 en forme de rainure est séparé de la face active 202B de la puce 202 par une distance notée D. Selon un mode de réalisation, la distance D est comprise entre 20 µm et 250 pm, de préférence entre 20 µm et 40 µm.

Plus la distance D est faible, plus la surface des faces latérales des évidements 214 est importante. En réduisant la distance D, on augmente donc la surface d'échange entre la puce 202 et le fluide, ce qui permet d'améliorer l'efficacité de refroidissement de la puce 202.

En outre, plus la distance D est faible et plus la portion de puce 202 séparant la face 202B du fond de chaque évidement 214 est mince. En réduisant la distance D, on diminue donc la résistance thermique entre la face active 202B de la puce 202 et le fluide caloporteur, ce qui permet d'améliorer encore davantage l'efficacité de refroidissement de la puce 202.

La figure 6 est une vue en perspective, schématique et partielle, illustrant un autre mode de réalisation d'un dispositif électronique destiné à être refroidi par une circulation de liquide.

Selon ce mode de réalisation, la puce 202 présente, vue de dessus, des évidements 214 constitués par une rainure en forme de serpentin dont les extrémités sont respectivement situées à proximité des orifices 218I et 2180. Bien que cela ne soit pas représenté en figure 6, la cavité 220 peut dans ce cas être omise afin de contraindre le fluide à circuler (flèches 226) à l'intérieur du canal en forme de serpentin.

Un avantage du mode de réalisation exposé en relation avec la figure 6 tient au fait que la circulation forcée du fluide entre les ailettes de la puce 202, séparées les unes des autres par les évidements 214, permet par exemple d'améliorer encore davantage le refroidissement de la puce 202 par rapport au mode de réalisation exposé en relation avec la figure 2.

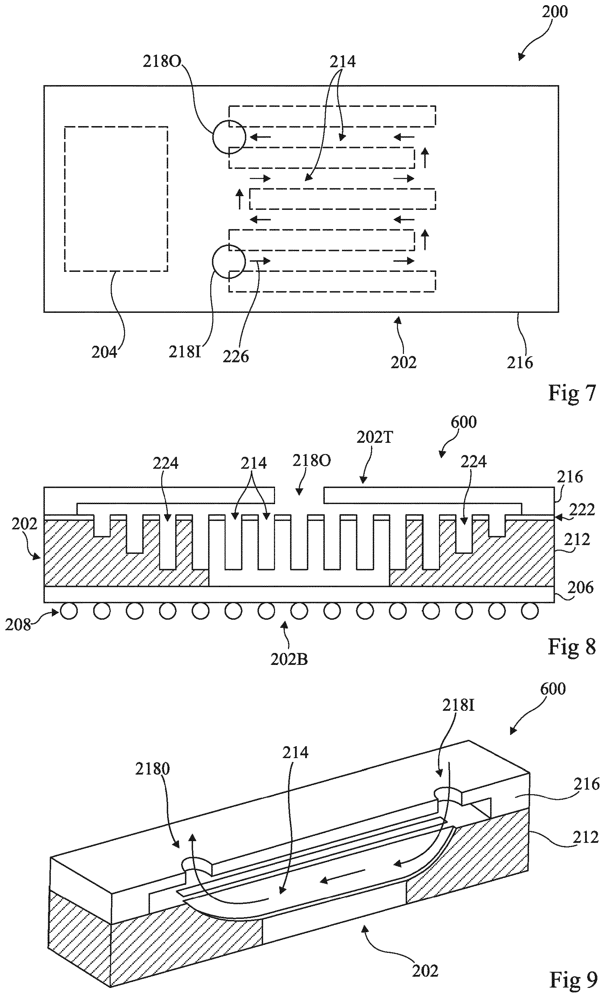

La figure 7 est une vue de dessus, schématique et partielle, du dispositif de la figure 6.

Dans l'exemple représenté, la circulation du fluide, symbolisée par les flèches 226, suit le serpentin formé par les évidements 214. En pratique, de l'eau froide est par exemple injectée par l'orifice d'entrée 218I tandis que de l'eau progressivement réchauffée lors de sa circulation entre et au contact des ailettes de la puce 202 est extraite par l'orifice de sortie 2180. On peut alors faire en sorte, notamment par un contrôle de débit d'eau approprié, que la température de sortie du fluide traversant l'orifice 2180 soit inférieure à un seuil permettant d'atteindre une puissance de refroidissement souhaitée de la puce 202.

La figure 8 est une vue en coupe, schématique et partielle, illustrant un autre mode de réalisation d'un dispositif électronique 600.

Le dispositif 600 de la figure 8 comprend des éléments communs avec le dispositif 200 de la figure 2. Ces éléments communs ne seront pas décrits à nouveau ci-après.

Le dispositif 600 de la figure 8 se distingue du dispositif 200 de la figure 2 principalement en ce que le dispositif 600 comporte des évidements 224 supplémentaires à l'intérieur du bloc 212 d'encapsulation. Le bloc 212 d'encapsulation est symbolisé, en figure 8, par des zones hachurées.

Les évidements 224, formés depuis la surface supérieure du bloc 212 d'encapsulation, constituent des canaux de circulation de liquide analogues à ceux constitués par les évidements 214, formés depuis la surface supérieure de la puce 202. En d'autres termes, les évidements 224 participent au refroidissement de la puce 202.

On a représenté en figure 8 un mode de réalisation dans lequel les évidements 224 les plus proches de la puce 202 présentent une profondeur supérieure aux évidements 224 les plus éloignés de la puce 202. Cela n'est toutefois pas limitatif, les évidements 224 pouvant par exemple tous présenter la même profondeur.

Un avantage du dispositif 600 de la figure 8 tient au fait que la présence des évidements 224 permet d'augmenter l'efficacité de la circulation du liquide. Les évidements 224 permettent en particulier de limiter les pertes de charge en favorisant la descente du liquide depuis l'orifice d'entrée 218I et la remontée du liquide vers l'orifice de sortie 2180.

La figure 9 est une vue schématique, en perspective et en coupe, du dispositif de la figure 8. Plus précisément, le plan de coupe de la figure 9 est perpendiculaire à la surface supérieure du capot 216 et passe par le centre des orifices 218I et 2180 du dispositif 600 de la figure 6.

Dans l'exemple représenté, les évidements 214 se prolongent longitudinalement à l'intérieur du bloc 212 d'encapsulation. Les évidements 214 présentent, vus de côté, une forme d'arc de cercle au voisinage des orifices 218I et 2180. Cela permet notamment un meilleur guidage du flux de liquide.

On a représenté ci-dessus, en relation avec les figures 2 à 9, des modes de réalisation dans lesquels les orifices 218I d'entrée et 2180 de sortie présentent chacun une forme cylindrique, de section circulaire, et dont l'axe est orienté perpendiculairement à la surface supérieure du capot 216. Cela n'est toutefois pas limitatif, les orifices pouvant en pratique présenter une forme quelconque. En particulier, les orifices peuvent présenter une forme de cylindre oblique, c'est-à-dire de cylindre dont l'axe est incliné par rapport à une normale à la surface supérieure du capot 216.

À titre d'exemple, les orifices 218I d'entrée et 2180 de sortie de fluide ne sont pas perpendiculaires à la face supérieure du capot 216, c'est-à-dire la face du capot 216 dans laquelle sont réalisés les orifices 218I et 2180. Les orifices 218I et 2180 forment alors, par exemple, un angle compris entre 45° et 70° par rapport à la normale à la face supérieure du capot 216, de sorte que le fluide n'entre et ne sort pas perpendiculairement par rapport à la direction des canaux 214. Cela permet par exemple une optimisation du flux liquide.

De manière générale, la personne du métier est en mesure d'adapter la forme des orifices 218I et 2180 de sorte à optimiser le guidage du fluide par rapport aux ailettes de la puce 202.

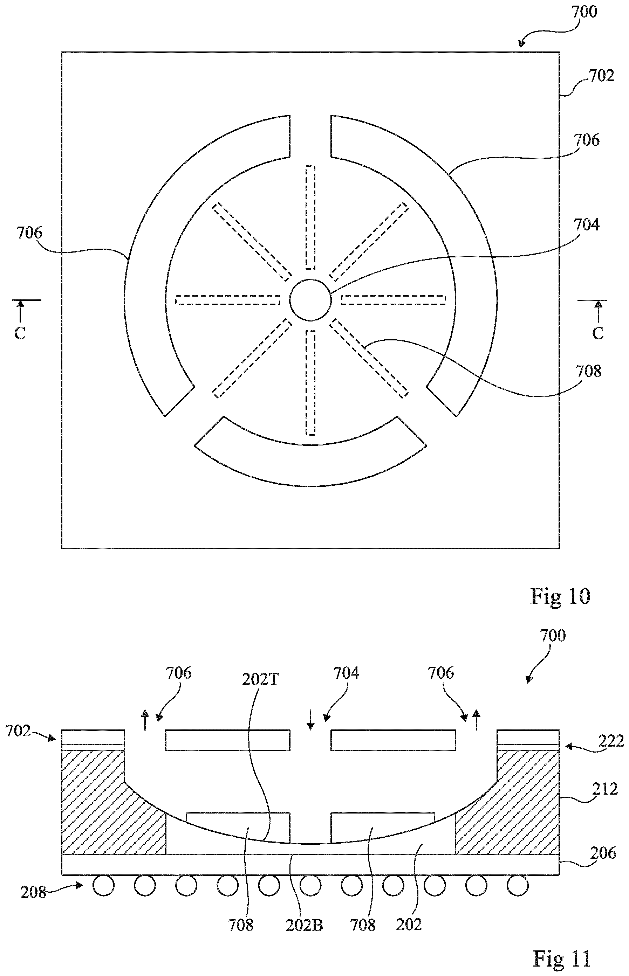

La figure 10 est une vue de dessus, schématique et partielle, illustrant encore un autre mode de réalisation d'un dispositif électronique 700.

Selon ce mode de réalisation, le dispositif 700 comporte un capot 702 au travers duquel sont formés :
un orifice 704 central destiné à permettre une injection de liquide caloporteur dans une région située sous le capot 702 ; et
des orifices 706 périphériques, en forme de secteur ou portion d'anneau, destinés à permettre l'évacuation du liquide caloporteur depuis la région située sous le capot 702.

Sous le capot 702, la circulation du liquide caloporteur est guidée par des ailettes 708. Les ailettes 708 sont disposées radialement, de sorte qu'une extrémité de chaque ailette est située à proximité de l'orifice 704 central tandis que l'autre extrémité de chaque ailette est située à proximité de l'un des orifices 706 périphériques. Les ailettes 708 définissent ainsi des canaux, en forme de secteur de disque, de circulation de liquide depuis l'orifice 704 d'injection vers les orifices 706 d'évacuation.

La figure 11 est une vue en coupe, selon le plan CC de la figure 10, schématique et partielle, du dispositif 700.

Le dispositif 700 des figures 10 et 11 comprend des éléments communs avec le dispositif 200 de la figure 2. Ces éléments communs ne seront pas décrits à nouveau ci-après.

Le dispositif 700 des figures 10 et 11 se distingue du dispositif 200 de la figure 2 principalement en ce que, dans le dispositif 700, la puce 202 comporte des évidements en forme de secteur de disque, chaque évidement étant délimité latéralement par deux ailettes 708.

Selon le mode de réalisation représenté en figure 11, la face supérieure 202T de la puce 202 a la forme d'une calotte sphérique ouverte vers le haut. En d'autres termes, la face 202T présente, vue en coupe, une forme d'arc de cercle. Cela permet de faire en sorte que l'épaisseur de la puce 202 soit plus faible au centre que sur les côtés. Cela permet principalement d'améliorer la circulation du liquide. Cela sert aussi, par exemple, dans le cas où l'on souhaite refroidir plus particulièrement des composants situés au milieu de la face 202B active de la puce 202.

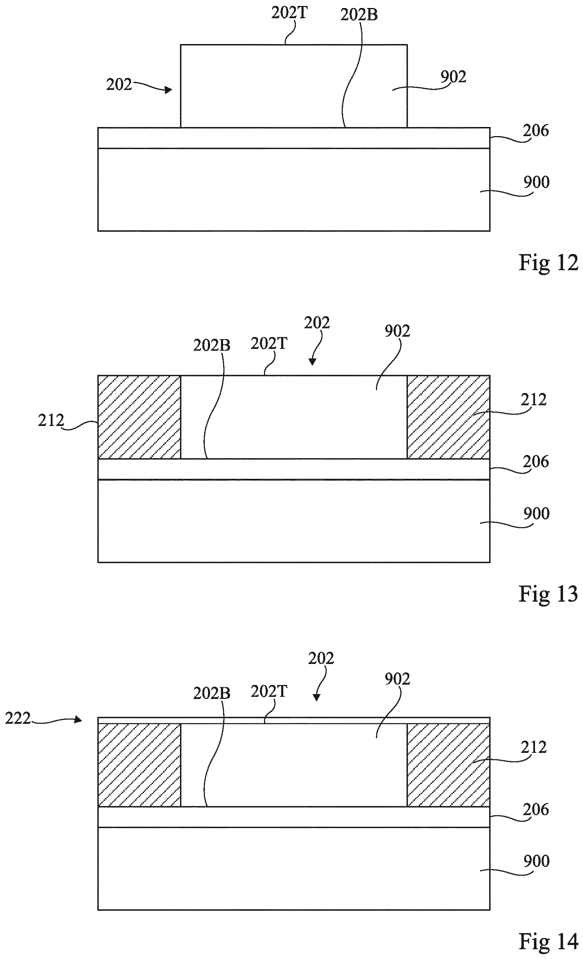

Les figures 12 à 18 ci-dessous décrivent des étapes successives d'un mode de mise en oeuvre d'un procédé de fabrication du dispositif électronique 200 de la figure 2.

La figure 12 est une vue en coupe, schématique et partielle, illustrant une étape du mode de mise en oeuvre du procédé de fabrication du dispositif électronique 200.

Au cours de cette étape, on reporte les puces électroniques 202 et 204 (seule la puce 202 est visible dans la vue en coupe de la figure 12) sur un support ou poignée 900.

On considère, pour simplifier, que la poignée 900 a déjà subi des opérations préalables (non détaillées) visant à réaliser, du côté de sa face supérieure, la structure 206 d'interconnexion telle que décrite en relation avec la figure 2. Lors du report sur la poignée 900, la puce 202 est mise en contact, par sa face 202B active, avec la face supérieure de la structure 206 d'interconnexion.

Selon un mode de réalisation, la puce 202 est formée dans et sur un substrat 902 semiconducteur. La puce 202 peut notamment être obtenue à l'issue d'une opération de découpe ou sciage d'une plaquette en un matériau semiconducteur, par exemple en silicium, dans et sur laquelle ont été réalisés des composants électroniques actifs. La face 202B de la puce 202 correspond à la face du substrat 902 dans et sur laquelle ont été réalisés les composants électroniques actifs.

À titre d'exemple, le substrat 902 présente une épaisseur comprise entre 700 nm et 800 nm, par exemple égale à 740 nm. La poignée 900 est, par exemple, en un matériau semiconducteur, en un matériau polymère ou en verre.

La figure 13 est vue en coupe, schématique et partielle, illustrant une autre étape du mode de mise en oeuvre du procédé de fabrication du dispositif 200.

Au cours de cette étape, on réalise le bloc 212 d'encapsulation entourant les faces latérales de la puce 202.

Le bloc 212 est, de préférence, obtenu à partir d'une couche de résine époxy déposée sur des portions libres de la face supérieure de la structure 206 d'interconnexion. La couche de résine est, par exemple, déposée de manière à recouvrir la puce 202. La couche de résine est ensuite amincie de sorte à exposer la face supérieure 202T de la puce 202, puis planarisée. On obtient ainsi, comme illustré en figure 13, un bloc 212 d'encapsulation présentant une face supérieure régulière et affleurant la face supérieure de la puce 202.

Dans les figures 13 à 18, le bloc 212 d'encapsulation est symbolisé par des zones hachurées.

La figure 14 est vue en coupe, schématique et partielle, illustrant encore une autre étape du mode de mise en oeuvre du procédé de fabrication du dispositif 200.

Au cours de cette étape, on dépose la couche 222 d'oxyde du côté de la face supérieure de la structure obtenue à l'issue de l'étape précédente.

La couche 222 revêt plus précisément la face supérieure du bloc 212 d'encapsulation et la face 202T supérieure de la puce 202. La couche 222 est est par exemple destinée à protéger le bloc 212 d'encapsulation contre l'humidité. On qualifie par exemple la couche 222 de couche barrière, ou de masque dur.

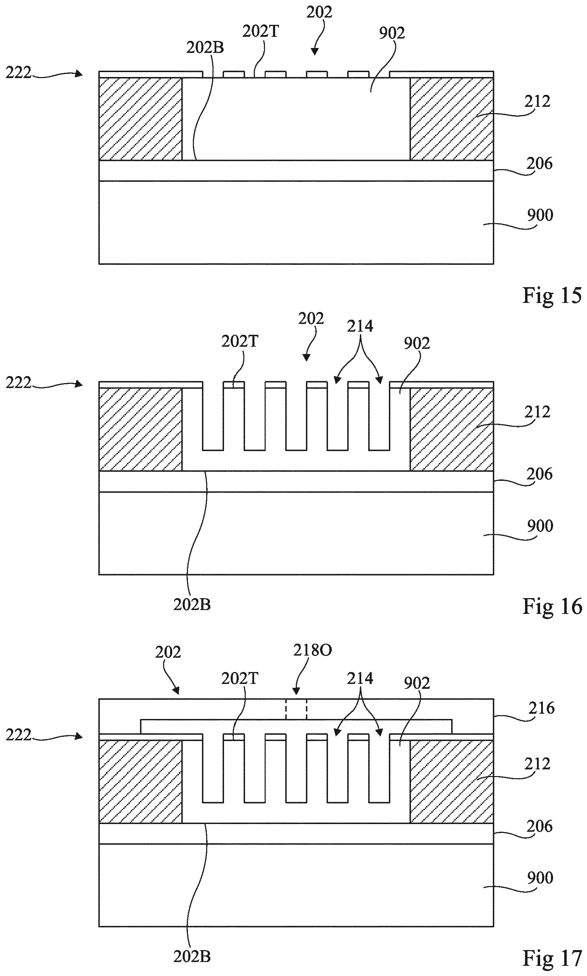

La figure 15 est vue en coupe, schématique et partielle, illustrant encore une autre étape du mode de mise en oeuvre du procédé de fabrication du dispositif 200.

Au cours de cette étape, on grave la couche 222 afin d'exposer des portions de face supérieure 202T de la puce 202.

L'opération de gravure de la couche 222 est, par exemple, réalisée par photolithogravure. En particulier, on peut prévoir de revêtir la couche 222 d'une couche (non représentée) de résine photosensible positive ou négative, d'insoler cette résine à travers un masque, puis de retirer des parties insolées (dans le cas d'une résine positive) ou non insolées (dans le cas d'une résine négative) de la couche de résine. On met ensuite à nu des portions de face supérieure 202T de la puce 202 en gravant des parties de couche 222 non recouvertes par la résine de photolithographie, puis on élimine la résine de photolithographie restante.

Au cours de cette étape, on peut de surcroît prévoir d'effectuer des opérations similaires pour exposer des portions de face supérieure du bloc 212 d'encapsulation.

La figure 16 est vue en coupe, schématique et partielle, illustrant encore une autre étape du mode de mise en oeuvre du procédé de fabrication du dispositif 200.

Au cours de cette étape, on grave la face supérieure 202T de la puce 202 pour former les évidements 214.

Les évidements 214 sont plus précisément réalisés en gravant la puce 202 à l'aplomb des portions de face 202T non recouvertes par les parties de couche 222 qui subsistent à l'issue de l'étape précédente. On forme ainsi des rainures ou sillons dans le substrat 902, ces rainures étant ouvertes du côté de la face supérieure 202T de la puce 202.

Selon un mode de mise en oeuvre préféré, les évidements 214 sont réalisés par gravure ionique réactive (Reactive Ion Etching - RIE), par exemple par gravure ionique réactive profonde (Deep Reactive Ion Etching - DRIE) .

Dans le cas (non représenté) où des portions de face supérieure du bloc 212 d'encapsulation ont été exposées à l'issue de l'étape précédente, on peut en outre procéder à une gravure du bloc 212 d'encapsulation à l'aplomb de portions de face supérieure du bloc 212 non recouvertes par la couche 222. On forme ainsi, par exemple, des évidements analogues aux évidements 224 décrits en relation avec la figure 8. La gravure du bloc 212 d'encapsulation est, de préférence, réalisée au laser. Cela permet par exemple de contrôler individuellement la profondeur de chaque évidement 224 (figure 8).

La figure 17 est vue en coupe, schématique et partielle, illustrant encore une autre étape du mode de mise en oeuvre du procédé de fabrication du dispositif 200.

Au cours de cette étape, on reporte le capot 216 du côté de la face supérieure de la structure obtenue à l'issue de l'étape précédente.

Le capot 216 est par exemple fixé sur des portions de couche 222 qui subsistent de part et d'autre de la puce 202. Selon un mode de mise en oeuvre, le capot 216 est en un matériau organique, de préférence une résine époxy. Le capot 216 est par exemple moulé préalablement à son report du côté de la face supérieure 202T de la puce 202.

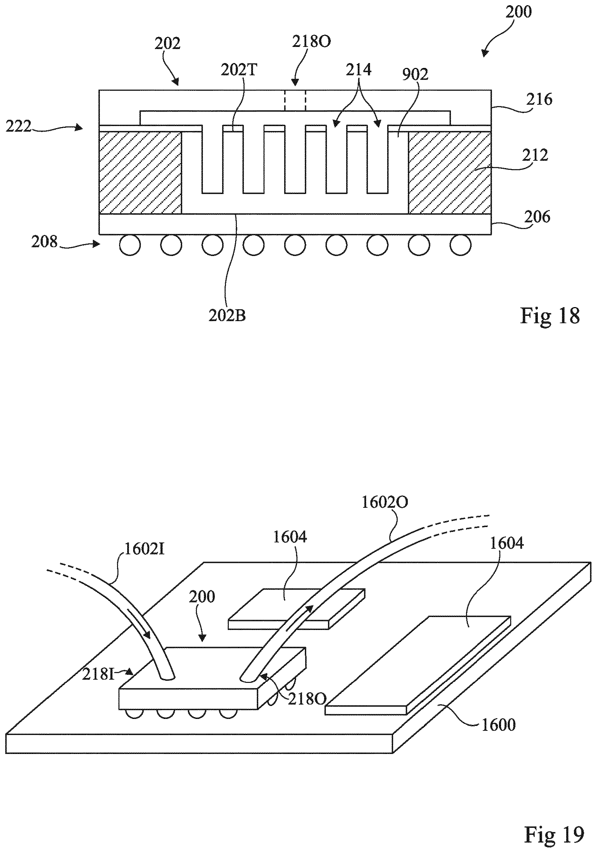

La figure 18 est vue en coupe, schématique et partielle, illustrant encore une autre étape du mode de mise en oeuvre du procédé de fabrication du dispositif 200.

Au cours de cette étape, on retire la poignée 900 et on réalise, du côté de la face inférieure de la structure 206 d'interconnexion, la matrice 208 de billes de soudure.

La poignée 900 est par exemple désolidarisée de la structure 206 d'interconnexion par chauffage.

On a décrit ci-dessus en relation avec les figures 12 à 18 un mode de mise en oeuvre d'un procédé de fabrication d'un seul dispositif 200. Toutefois, en pratique, ce procédé peut avantageusement être mis en oeuvre pour réaliser simultanément un nombre quelconque de dispositifs 200, par exemple plusieurs dizaines de dispositifs 200. En particulier, on peut prévoir de reporter plusieurs puces 202 sur une même poignée 900 constituée alors, par exemple, d'une plaquette entière. Les faces latérales respectives des puces 202 sont alors, de préférence, séparées par des portions de bloc 212 d'encapsulation. Dans ce cas, les capots 216 de tous les dispositifs 200 réalisés sur la poignée 900 peuvent avantageusement être obtenus à partir d'une même pièce.

La figure 19 est une vue en perspective, schématique et partielle, d'une carte 1600 de circuit imprimé comportant un dispositif électronique à refroidissement liquide, par exemple le dispositif 200.

Dans l'exemple représenté, l'orifice 218I d'injection de liquide du dispositif 200 est raccordé à une conduite 1602I d'arrivée d'eau. De façon analogue, l'orifice 2180 d'évacuation de liquide du dispositif 200 est raccordé à une conduite 16020 de sortie d'eau. Les conduites 1602I et 16020 permettent d'imposer une circulation d'eau à l'intérieur du dispositif 200. Les conduites 1602I et 16020, par exemple des capillaires, sont de dimensions adaptées à la taille du dispositif 200 et de ses orifices 218I et 2180.

La présence, dans le dispositif 200, d'une puce 202 comportant des évidements 214 (figure 2) permet d'améliorer l'efficacité de refroidissement du dispositif 200 par rapport à un dispositif qui comporterait une puce équipée d'un dissipateur thermique usuel. Cela permet, par exemple, de faire fonctionner la puce 202 du dispositif 200 à une fréquence plus élevée et/ou sous un courant électrique plus important. Dans le cas, par exemple, d'un supercalculateur comportant plusieurs milliers, voire plusieurs dizaines ou centaines de milliers, de cartes 1600, cela peut en outre permettre une réduction de consommation énergétique liée au refroidissement du supercalculateur.

À titre d'exemple, la carte 1600 peut comporter d'autres dispositifs électroniques schématisés, en figure 19, par des parallélépipèdes 1604. Certains dispositifs 1604 peuvent par exemple être refroidis par eau, à l'instar du dispositif 200, tandis que d'autres dispositifs 1604 sont par exemple refroidis par air.

Enfin, la mise en oeuvre pratique des modes de réalisation et modes de mise en oeuvre décrits est à la portée de la personne du métier à partir des indications fonctionnelles données ci-dessus. En particulier, le choix de la localisation et de la géométrie des évidements en fonction de la puce 202 à refroidir est à la portée de la personne du métier.

## Revendications

1. Système comportant :
une puce électronique (202) formée dans et sur un substrat (902) semiconducteur comportant, du côté d'une première face (202B), au moins un composant actif et, du côté d'une deuxième face (202T) opposée à la première face, au moins un premier canal de circulation d'un liquide destiné à refroidir la puce ; et
un bloc (212) en un matériau organique, de préférence une résine époxy, entourant la puce sur toutes ses faces latérales, le bloc comportant au moins un deuxième canal (224) de circulation d'un liquide,
ledit système étant **caractérisé en ce que** chaque premier canal est défini par un évidement (214) depuis la deuxième face du substrat se prolongeant longitudinalement, hors de la puce, à l'intérieur du bloc.

2. Système selon la revendication 1, dans lequel chaque évidement (214) a la forme d'une rainure droite ouverte côté deuxième face (202T) du substrat (902).

3. Système selon la revendication 2, dans lequel le fond de chaque rainure est séparé de la première face (202B) du substrat (902) par une distance (D) comprise entre 20 µm et 250 pm, de préférence entre 20 µm et 40 µm.

4. Système selon l'une quelconque des revendications 1 à 3, dans lequel le premier canal présente, vu de dessus, une forme de serpentin.

5. Système selon la revendication 1, dans lequel chaque évidement (214) a la forme d'un secteur de disque bordé latéralement par deux ailettes (708) radiales.

6. Dispositif électronique (200 ; 600 ; 700) comprenant :
un système selon l'une quelconque des revendications 1 à 5 ; et
un capot (216 ; 702) situé en regard de la deuxième face (202T) du substrat (902).

7. Dispositif selon la revendication 6, dans lequel le capot (216 ; 702) forme un espace (220) de distribution du liquide dans chaque canal.

8. Dispositif selon la revendication 6 ou 7, dans lequel le capot (216 ; 702) comporte un orifice (218I ; 704) d'injection de liquide et un orifice (2180 ; 706) d'évacuation de liquide.

9. Dispositif selon la revendication 8, dans lequel chaque premier canal présente une première extrémité située à proximité de l'orifice (218I ; 704) d'injection de liquide et une deuxième extrémité située à proximité de l'orifice (2180 ; 706) d'évacuation de liquide.

10. Dispositif selon la revendication 8 ou 9, dans lequel l'orifice (218I ; 704) d'injection de liquide et l'orifice (2180 ; 706) d'évacuation de liquide forment, par rapport à une normale à la face supérieure du capot (216 ; 702), un angle compris entre 45° et 70°.

11. Dispositif selon l'une quelconque des revendications 6 à 10, dans lequel le capot (216 ; 702) est en un matériau organique, de préférence une résine époxy.

12. Procédé de fabrication d'un dispositif (200 ; 600 ; 700) selon l'une quelconque des revendications 6 à 11, comprenant les étapes suivantes :
déposer une couche (222) d'oxyde sur la deuxième face (202T) du substrat (902) ;
graver la couche d'oxyde ;
réaliser le premier canal (214) de circulation au droit d'une portion de deuxième face du substrat non revêtue par la couche d'oxyde ; et
fixer le capot (216 ; 702) en regard de la deuxième face du substrat.

13. Procédé selon la revendication 12, dans lequel le premier canal (214) de circulation est réalisé par gravure ionique réactive.

## Patentansprüche

1. System, das Folgendes aufweist:
einen elektronischen Chip (202), der auf der Oberseite und im Inneren eines Halbleitersubstrats (902) ausgebildet ist, das auf der Seite einer ersten Oberfläche (202B) mindestens eine aktive Komponente aufweist und auf der Seite einer zweiten Oberfläche (202T), die zur ersten Oberfläche entgegengesetzt ist, mindestens einen ersten Kanal für die Zirkulation einer Flüssigkeit aufweist, die dazu bestimmt ist, den Chip zu kühlen; und
einen Block (212) aus einem organischen Material, vorzugsweise Epoxidharz, der den Chip an allen seinen Seitenflächen umgibt, wobei der Block mindestens einen zweiten Kanal (224) für die Zirkulation einer Flüssigkeit aufweist,
wobei das System **dadurch gekennzeichnet ist, dass** jeder erste Kanal durch eine Ausnehmung (214) in der zweiten Oberfläche des Substrats definiert ist, die sich in Längsrichtung über den Chip hinaus in das Innere des Blocks erstreckt.

2. System nach Anspruch 1, wobei jede Ausnehmung (214) die Form einer geraden Nut hat, die auf der Seite der zweiten Oberfläche (202T) des Substrats (902) offen ist.

3. System nach Anspruch 2, wobei der Boden jeder Nut von der ersten Oberfläche (202B) des Substrats (902) durch einen Abstand (D) im Bereich von 20°µm bis 250 µm, vorzugsweise von 20 µm bis 40 µm, getrennt ist.

4. System nach einem der Ansprüche 1 bis 3, wobei der erste Kanal in der Draufsicht eine Serpentinenform aufweist.

5. System nach Anspruch 1, wobei jede Aussparung (214) die Form eines Scheibensektors aufweist, der seitlich von zwei radialen Rippen (708) begrenzt wird.

6. Elektronische Vorrichtung (200; 600; 700), die Folgendes aufweist:
ein System gemäß einem der Ansprüche 1 bis 5; und
eine Abdeckung (216; 702), die gegenüber der zweiten Oberfläche (202T) des Substrats (902) angeordnet ist.

7. Vorrichtung gemäß Anspruch 6, wobei die Abdeckung (216; 702) einen Raum (220) zum Verteilen der Flüssigkeit in jeden Kanal bildet.

8. Vorrichtung nach Anspruch 6 oder 7, wobei die Abdeckung (216; 702) eine Flüssigkeitseinlassöffnung (2181; 704) und eine Flüssigkeitsauslassöffnung (2180; 706) aufweist.

9. Vorrichtung nach Anspruch 8, wobei jeder erste Kanal ein erstes Ende, das sich in der Nähe der Flüssigkeitseinlassöffnung (2181; 704) befindet, und ein zweites Ende, das sich in der Nähe der Flüssigkeitsauslassöffnung (2180; 706) befindet, aufweist.

10. Vorrichtung nach Anspruch 8 oder 9, wobei die Flüssigkeitseinlassöffnung (2181; 704) und die Flüssigkeitsauslassöffnung (2180; 706) in Bezug auf eine Senkrechte zur oberen Fläche der Abdeckung (216; 702) einen Winkel im Bereich von 45° bis 70° bilden.

11. Vorrichtung nach einem der Ansprüche 6 bis 10, wobei die Abdeckung (216; 702) aus einem organischen Material, vorzugsweise Epoxidharz, hergestellt ist.

12. Verfahren zur Herstellung einer Vorrichtung (200; 600; 700) nach einem der Ansprüche 6 bis 11, das die folgenden Schritte aufweist:
Abscheiden einer Oxidschicht (222) auf der zweiten Oberfläche (202T) des Substrats (902);
Ätzen der Oxidschicht;
Ausbilden des ersten Zirkulationskanals (214) vertikal in einem Abschnitt der zweiten Oberfläche des Substrats, der nicht mit der Oxidschicht beschichtet ist; und
Bonden der Abdeckung (216; 702) gegenüber der zweiten Oberfläche des Substrats.

13. Verfahren nach Anspruch 12, wobei der erste Zirkulationskanal (214) durch reaktives lonenätzen ausgebildet wird.

## Claims

1. System comprising:
an electronic chip (202) formed on top and inside of a semiconductor substrate (902) comprising, one the side of a first surface (202B), at least one active component and, on the side of a second surface (202T) opposite to the first surface, at least one first channel for the circulation of a liquid intended to cool the chip; and
a block (212) made of an organic material, preferably epoxy resin, surrounding the chip on all its lateral surfaces, the block comprising at least one second channel (224) for the circulation of a liquid, said system being **characterized in that** each first channel is defined by a recess (214) from the second surface of the substrate which extends longitudinally, out of the chip, inside the block.

2. System according to claim 1, wherein each recess (214) has the shape of a straight groove opened on the side of the second surface (202T) of the substrate (902).

3. System according to claim 2, wherein the bottom of each groove is separated from the first surface (202B) of the substrate (902) by a distance (D) in the range from 20 µm to 250 pm, preferably from 20 µm to 40 µm.

4. System according to any one of claims 1 to 3, wherein the first channel has, in top view, a serpentine shape.

5. System according to claim 1, wherein each recess (214) has the shape of a disk sector laterally bordered with two radial fins (708).

6. Electronic device (200; 600; 700) comprising:
a system according to any one of claims 1 to 5; and
a cover (216; 702) located opposite the second surface (202T) of the substrate (902).

7. Device according to claim 6, wherein the cover (216; 702) forms a space (220) for distributing the liquid into each channel.

8. Device according to claim 6 or 7, wherein the cover (216; 702) comprises a liquid injection port (218I; 704) and a liquid discharge port (2180; 706).

9. Device according to claim 8, wherein each first channel has a first end located close to the liquid injection port (218I; 704) and a second end located close to the liquid discharge port (2180; 706).

10. Device according to claim 8 or 9, wherein the liquid injection port (218I; 704) and the liquid discharge port (2180; 706) form, with respect to a normal to the upper surface of the cover (216; 702), an angle in the range from 45° to 70°.

11. Device according to any one of claims 6 to 10, wherein the cover (216; 702) is made of an organic material, preferably epoxy resin.

12. Method of manufacturing a device (200; 600; 700) according to any one of claims 6 to 11, comprising the steps of:
depositing an oxide layer (222) on the second surface (202T) of the substrate (902);
etching the oxide layer;
forming the first circulation channel (214) vertically in a portion of the second surface of the substrate which is not coated with the oxide layer; and
bonding the cover (216; 702) in front of the second surface of the substrate.

13. Method according to claim 12, wherein the first circulation channel (214) is formed by reactive ion etching.
